# EUROPEAN PATENT SPECIFICATION

(11) **EP 3 221 673 B1**
(45) Date of publication and mention of the grant of the patent: **29.05.2019**
(21) Application number: 15801592.5
(22) Date of filing: 13.11.2015
(51) Int. Cl.: B82Y 20/00

(54) **MULTI-LAYER ADVANCED CARBON NANOTUBE BLACKBODY FOR COMPACT, LIGHTWEIGHT, AND ON-DEMAND INFRARED CALIBRATION**
MEHRSCHICHTIGER FORTSCHRITTLICHER SCHWARZKÖRPER AUS KOHLENSTOFFNANORÖHRCHEN FÜR KOMPAKTE, LEICHTGEWICHTIGE UND ON-DEMAND-INFRAROTKALIBRIERUNG
CORPS NOIR DE NANOTUBE DE CARBONE AVANCÉ MULTICOUCHE POUR ÉTALONNAGE INFRAROUGE COMPACT, LÉGER ET À LA DEMANDE

(30) Priority: 19.11.2014 US 201414548135
(43) Date of publication of application: 27.09.2017
(73) Proprietor: Raytheon Company, Waltham, MA 02451-1449 (US)
(72) Inventor: CHOW, James R., El Segundo, CA 90245 (US); KETOLA, Kurt S., El Segundo, CA 90245 (US); LA KOMSKI, David M., Long Beach CA 90808 (US); TOWNSEND, Carl W., El Segundo, CA 90245 (US); ELIAS, William E., Manhattan Beach CA 90266-2670 (US); MARBLE, Stuart J., El Segundo, CA 90245 (US)
(74) Representative: Carpmaels & Ransford LLP
(86) International application number: PCT/US2015/060526
(87) International publication number: WO 2016/081293

(56) References cited:
- WO-A1-2014/186026
- KR-A- 20130 106 932
- US-A1- 2013 048 884
- US-A1- 2013 087 758
- US-A1- 2013 153 860
- US-A1- 2013 329 366
- W. KONZ ET AL: "<title>Micromachined IR-source with excellent blackbody like behaviour (Invited Paper)</title>", MEDICAL IMAGING 2002: PACS AND INTEGRATED MEDICAL INFORMATION SYSTEMS: DESIGN AND EVALUATION, vol. 5836, 1 July 2005 (2005-07-01), pages 540-548, XP055250167, 1000 20th St. Bellingham WA 98225-6705 USA ISSN: 0277-786X, DOI: 10.1117/12.608712 ISBN: 978-1-5106-0167-3

## Description

### BACKGROUND

The present disclosure relates to generating a radiation spectrum and, in particular, to a method and apparatus for generating blackbody radiation spectra.

In various optical systems, an optical signal is received from an object at an optical sensor and measurements of the optical signal are obtained at the optical sensor to determine a property of the object. In order to obtain accurate measurements, it is often necessary to calibrate the optical sensor using a known photon flux at one or more standard wavelengths. One method for providing the photon flux at standard wavelengths includes heating one or more blackbody radiators to selected temperatures and using optical filters to select the calibration wavelength. However, the use of blackbody sources to calibrate an optical sensor introduces size, weight, and power (SWaP) challenges. First of all, a conventional blackbody radiator needs to be heated for a relatively long time prior to use in calibration in order to bring the blackbody radiator to the selected temperature and to maintain the selected temperature. Conventional blackbody sources therefore consume a large amount of power. Secondly, conventional blackbody sources and their supporting optical structures are generally bulky, and using one or more of them requires a precise optical mechanism to image each blackbody emission spectrum onto the sensor undergoing calibration. Third, such a blackbody radiator calibration system and its accompanying optical mechanisms are generally heavy and cumbersome.

Prior art is known from W. KONZ ET AL: "Micromachined IR-source with excellent blackbody like behaviour", MEDICAL IMAGING 2002: PACS AND INTEGRATED MEDICAL INFORMATION SYSTEMS: DESIGN AND EVALUATION, vol. 5836, 1 July 2005 (2005-07-01), pages 540-548, XP055250167; US 2013/329366 A1; KR 2013 0106932; and US 2013/153860 A1.

### SUMMARY

According to one embodiment of the present disclosure, an apparatus for producing a blackbody radiation spectrum is defined in claim 1 hereinafter.

According to another embodiment of the present disclosure, a method of producing a blackbody radiation spectrum is defined in claim 10 hereinafter.

Additional features and advantages are realized through the techniques of the present disclosure. Other embodiments and aspects of the disclosure are described in detail herein and are considered a part of the claimed disclosure. For a better understanding of the disclosure with the advantages and the features, refer to the description and to the drawings.

### BRIEF DESCRIPTION OF THE SEVERAL VIEWS OF THE DRAWINGS

The subject matter which is regarded as the disclosure is particularly pointed out and distinctly claimed in the claims at the conclusion of the specification. The forgoing and other features, and advantages of the disclosure are apparent from the following detailed description taken in conjunction with the accompanying drawings in which:
Figure 1 shows an exemplary optical system for detecting light or an optical signal according to an exemplary embodiment;
Figure 2 shows a detailed view of the exemplary calibration apparatus shown in Figure 1;
Figure 3 shows a detailed view of the of the exemplary thin film structure of Figure 2;
Figure 4 illustrates a response time for achieving an equilibrium temperature when applying a current to an exemplary carbon nanotube film of the present disclosure;
Figure 5 shows a table illustrating a relation between current supplied to the exemplary carbon nanotube film of Figure 4 and resulting spatial and temporal equilibrium temperatures of the carbon nanotube film; and
Figure 6 shows a cross-sectional view of the thin film structure of the present disclosure in an alternate embodiment.

### DETAILED DESCRIPTION

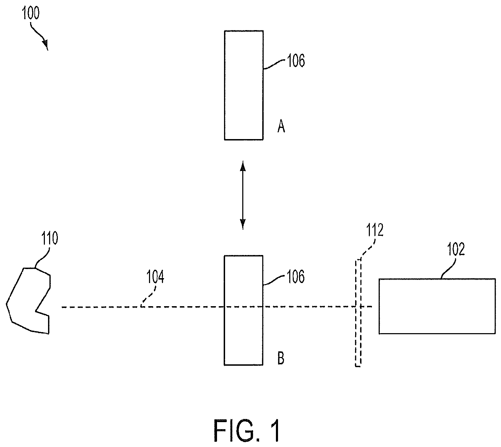

Figure 1 shows an exemplary optical system 100 for detecting light or an optical signal according to an exemplary embodiment. The optical system 100 includes a sensor 102, such as an optical sensor or optical detector. Light or optical signals propagating along the optical path 104 from a selected object or target 110 are detected at the sensor 102. In order to maintain sensor accuracy, a calibration apparatus 106 ("calibrator") is moved into the optical path 104. In an exemplary embodiment, the optical system 100 may operate in a sensing mode in which the calibration apparatus 106 is located at a first location A out of the optical path 104 of the optical sensor 102. The optical system 100 may also operate in a calibration mode in which the calibration apparatus 106 is moved to a second location B in the optical path 104 of the optical sensor 102. Once in the optical path 104, the calibration apparatus 106 blocks light or optical signals from the object 110 from reaching the optical sensor 102. The calibration apparatus 106 is then operated to provide light at one or more calibration wavelengths to the sensor 102 in order to calibrate the sensor 102. A filter 112 is shown that is placed between the calibration apparatus 106 and the sensor 102 when the calibration apparatus 106 is at second location B. The filter 112 allows a photon flux within a selected wavelength window corresponding to a calibration wavelength to reach the sensor 102 in order to calibrate the sensor 102 to the calibration wavelength. In an exemplary embodiment, a wavelength window is from about 3 microns to about 5 microns.

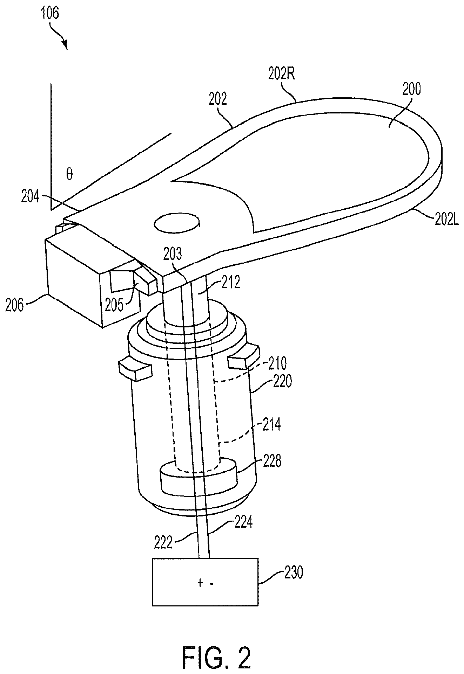

Figure 2 shows a detailed view of the exemplary calibration apparatus 106 shown in Figure 1. The exemplary calibration apparatus 106 includes a thin film structure 200 providing an extended surface area for emitting light or photons at a range of wavelengths. The thin film structure 200 may be bounded by a brace structure 202 that is coupled to the edges of the thin film structure 200. In an exemplary embodiment, the brace structure 202 is configured to apply a slight outward force in the plane of the thin film structure 200 in order to maintain a substantially flat surface of the thin film structure 200. Ends 203 and 204 of the brace structure 202 may be coupled or secured to a unit 206 via a securing device 205 such as a screw, bolt, etc. When secured to the unit 206, the ends 203 and 204 are further coupled to an upper end 212 of a rod 210. The rod 210 includes the upper end 212 for coupling to the thin film structure 200 via brace ends 203 and 204 and a lower end 214 extending within a housing 220. The rod 210 is rotatable within the housing 220 and an actuator assembly 228 of the housing 220 is used to rotate the rod 210 and hence the thin film structure 200 through a selected angle *θ*. The calibration apparatus 106 may be oriented with respect to the sensor 102 such that rotation of the rod 210 through angle *θ* moves the thin film structure 200 from a first location (e.g., location A in Figure 1) to a second location (e.g., location B in Figure 1). Alternatively, the calibration apparatus 106 may be linearly displaced between the first location and the second location.

In various embodiments, wires 222 and 224 traverses an interior of the rod and/or housing to the brace structure 202. Wire 222, disposed along a right side 202R of the brace structure 202, provides an electrical coupling to one edge of the thin film structure 200. Wire 224, disposed along a left side 202L of the brace structure 202, provides an electrical coupling to an opposing edge of the thin film structure 200. At a location distal to the brace structure 202, the wires 222 and 224 are coupled to opposing poles of a controllable power supply 230. Therefore, a current circuit is completed to provide current from the positive pole of the power supply 230 through wire 222 into the right side 202R of the brace structure 202, across the thin film structure 200 into wire 224 at the left side 202L of the brace structure 202, and into negative pole of the power supply 230. Variable voltage is supplied to the thin film structure 200 via the controllable power supply 230. In various aspects, applying a current to the thin film structure 200 raises a temperature of the thin film structure 200. At a selected temperature, the thin film structure 200 generally emits photons having a characteristic blackbody radiation spectrum, wherein the blackbody radiation spectrum includes a characteristic wavelength indicating a peak emission of the spectrum and that is related to the temperature of the thin film structure 200. In general, a total number of photons emitted by a blackbody radiator, as well as a number of photons emitted by the blackbody radiation within a selected range of wavelengths, are related to its temperature. As the temperature increases, the total photon flux and the photon flux within the selected wavelength range also increase. An operator may control the voltage or current at the controllable power supply 230 to cause a selected blackbody radiation spectrum to be emitted at the thin film structure 200. A characteristic wavelength and other features of the radiation spectrum is related to the magnitude or amount of the applied voltage. A photon flux within the selected range of wavelengths may then be measured at the optical sensor 102 to calibrate the optical sensor 102.

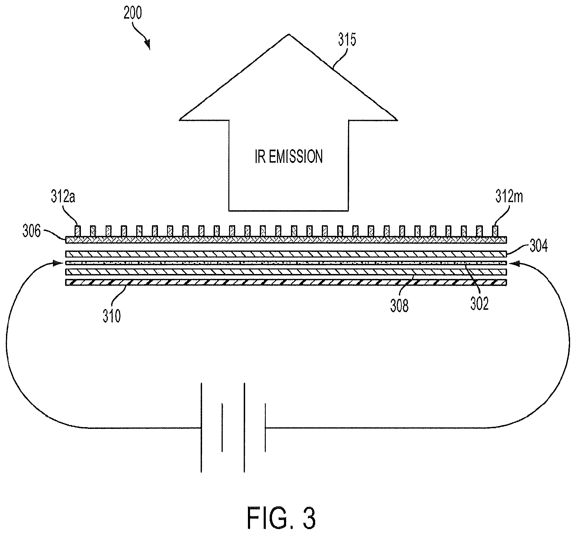

Figure 3 shows a detailed view of the of the exemplary thin film structure 200 of Figure 2. In an exemplary embodiment, thin film structure 200 includes a first carbon nanotube layer 302. The first carbon nanotube layer 302 includes a sheet of carbon nanotubes generally oriented to lie within the plane of the first carbon nanotube layer 302. One end of the first carbon nanotube layer 302 is coupled to a positive pole of a controllable power supply 320 and an opposing end of the first carbon nanotube layer 302 is coupled to a negative pole of the controllable power supply 320 in order to complete an electrical circuit through the first carbon nanotube layer 302. A first thermally conductive layer 304 is coupled to a top surface of the first carbon nanotube layer 302, wherein the top surface is the surface of the first carbon nanotube layer 302 facing toward the IR emission arrow 315. A second thermally conductive layer 308 is coupled to a bottom surface of the first carbon nanotube layer 302, wherein the bottom surface is the surface of the first carbon nanotube layer 302 facing away from the IR emission arrow 315. In various embodiments, the first and second thermally conductive layers 304 and 308 are made of an electrically insulating material such as a ceramic material. A second carbon nanotube layer 306 is coupled to the first thermally conductive layer 304 opposite the first carbon nanotube layer 302. The second carbon nanotube layer 306 is configured to emit photons in a selected direction as indicated by IR emission arrow 315 in response to heat generated at the first carbon nanotube layer 302. The second carbon nanotube layer 306 includes a plurality of carbon nanotubes 312a-312m oriented so that the longitudinal axes of the plurality of carbon nanotubes 312a-312m are substantially normal to the surface of the second carbon nanotube layer 306. In general, photons excited at the second carbon nanotube layer 306 are emitted into the half-space above the second carbon nanotube layer 306 containing the indicative IR emission arrow 315. Those photons that are emitted in the normal direction indicated by IR emission arrow 315 are used for calibration, as indicated by IR emission arrow 315. In various embodiments, emissivity of the second carbon nanotube layer 306 is greater than about 0.995. A low emissivity metal film 310 is coupled to a surface of the second thermally conductive layer 308 opposite the first carbon nanotube layer 302. In various embodiments, the low emissivity metal film 310 is configured to prevent heat from being radiated from the back end of the calibration apparatus thin film structure 200.

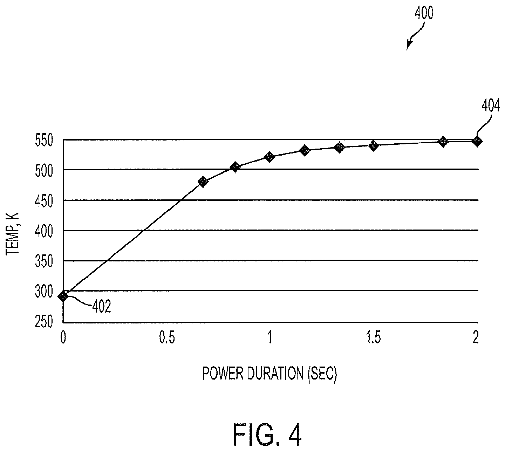

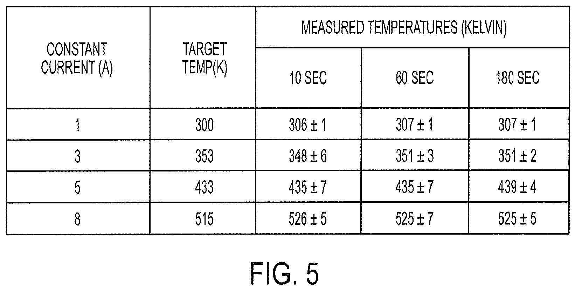

To operate the exemplary thin film structure 200, controllable power supply 320 supplies an electrical current to the first carbon nanotube layer 302 which generates heat in response to the supplied electrical current. The temperature and the amount of heat generated at the first carbon nanotube layer 302 are directly related to the amount of applied power. The first carbon nanotube layer 302 responds quickly to reach a selected equilibrium temperature when a current suitable for obtaining the equilibrium temperature is applied, as discussed below with respect to Figure 4. In an exemplary embodiment, the first carbon nanotube layer 302 reaches an equilibrium temperature within seconds of applying current to the first carbon nanotube layer 302. The temperature at the surface of the first carbon nanotube layer 302 generally has a spatial variation described below with respect to Figure 5. The spatial variation is in a temperature range of a few Kelvin. The heat generated at the first carbon nanotube layer 302 is dispersed through first thermally conductive layer 304 to excite photons at a broad range of wavelengths at the second carbon nanotube layer 306. The first thermally conductive layer 304 disperses heat generated at the first carbon nanotube layer 302 in the plane of the first thermally conductive layer 304. Thus, any variations in temperature and heat generation at the first carbon nanotube layer 302 are substantially smoothed once the heat reaches the second carbon nanotube layer 306. In various embodiments, the temperature at the second carbon nanotube layer 306 has a spatial variation of less than 1.0 Kelvin across the surface of the second carbon nanotube layer 306. In another embodiment, the spatial variation is less than 0.5 Kelvin. In yet another embodiment, the spatial variation is less than 0.1 Kelvin. Thus, each of the plurality of carbon nanotubes 312a-312m at the second carbon nanotube layer 306 receives substantially a same amount of heat from the first thermally conductive layer 304. The heat received at the second carbon nanotube layer 306 excites photons which are directed along the longitudinal axis of the plurality of carbon nanotubes 312a-312m and thus generally propagate along the direction indicated by IR emission arrow 315. In addition, a flux of photons is also emitted in off-normal directions. The resulting spectrum from the second carbon nanotube layer 306 therefore is substantially equivalent to a blackbody radiation spectrum for a conventional blackbody heated to a substantially uniform temperature.

Figure 4 illustrates a response time for achieving an equilibrium temperature at the first carbon nanotube layer 302 when applying a current to an exemplary carbon nanotube film 200 of the present disclosure. Temperature is plotted along the ordinate axis in Kelvin and time is plotted along the abscissa in seconds. A voltage is applied to the first carbon nanotube layer 302 at time t=0 (402). Prior to time t=0 seconds, no current is supplied and the first carbon nanotube layer 302 is at a room temperature, i.e., about 290 K. Supplying the electrical current at time t=0 (402) causes the temperature of the first carbon nanotube layer 302 to rise to an equilibrium temperature of about 550 K at about t=2 seconds (404).

In contrast, conventional blackbody sources require from several minutes to several hours to reach an equilibrium temperature. Additionally, due to the length of time required to bring the conventional blackbody sources to an equilibrium temperature, the conventional blackbody sources are generally maintained at or near their equilibrium temperatures when not in calibration mode in order to be substantially prepared when calibration is needed. Calibration systems that use conventional blackbody sources therefore consume a large amount of power. Since the thin film structures of the present disclosure are able to reach equilibrium temperatures in relatively short time (i.e., less than about 20 seconds), there is no need to maintain the thin film structure at the equilibrium temperature during non-calibration times. Additionally, the thin film structure may thus be used to calibrate the sensors within an acceptable time frame, such as in less than 20 seconds. It is to be appreciated, however, that use of the thin film structure need not be limited to operations in which an expected time frame for completing a relevant task is 20 seconds or less. Therefore, calibrating optical sensors using the exemplary thin film structure of the present disclosure may be used on-demand which can save greater than about 90% of the operational costs over calibration methods using conventional blackbody sources.

Figure 5 shows a table illustrating a relation between current supplied to the exemplary carbon nanotube film 200 and equilibrium temperatures of the first carbon nanotube layer 302 of the thin film structure 200. The first column indicates an amount of current (in Amps) applied to the first carbon nanotube layer 302. The second column indicates a target temperature (in Kelvin) that is expected to be achieved when the selected current is applied. Columns 3, 4 and 5 show measured temperatures (in Kelvin) achieved when the selected voltage is applied to the first carbon nanotube layer 302 at times of 10 seconds, 60 seconds and 180 seconds, respectively. Spatial variations in temperature are also shown by the second number provided in each of Columns 3, 4 and 5 (i.e., "±1," "±6," etc.). The actual temperatures show relatively small spatial variation in temperature and are stable over the shown times (i.e., 10 seconds, 60 seconds and 180 seconds). Spreading the heat from the first carbon nanotube layer 302 through the first thermally conductive layer 304 reduces the spatial variation to within a selected range that is less than about 1.0 Kelvin, about 0.5 Kelvin or about 0.1 Kelvin, in various embodiments. Thus, the second carbon nanotube layer 306 is uniformly heated and each of the plurality of carbon nanotubes 312a-312m emits a blackbody radiation spectrum corresponding to substantially the same temperature. Selecting the amount of current supplied to the first carbon nanotube layer 302 therefore substantially controls a blackbody radiation spectrum produced at the second carbon nanotube layer 306. Thus, over a suitable calibration time frame, the thin film structure can be used to provide a substantially blackbody radiation spectrum suitable for use in calibrating a sensor. In alternative embodiments, the spreading of the heat from the first carbon nanotube layer 302 through the first thermally conductive layer 304 can be used to reduce the spatial variation to within a range of about 2 Kelvin or about 3 Kelvin. It is to be appreciated that the thin film structure can be used to reduce the spatial variation of temperature to within about 1.0 Kelvin even in operations in which such reduction in spatial variation of temperature is not needed.

Due to the relatively quick response of the thin film structure to the applied power, the blackbody radiation spectrum provide by the calibration apparatus 106 may be altered in a relatively quick amount of time. Therefore, the calibration apparatus 106 may be used to quickly provide multiple blackbody radiation spectra to the sensor.

In an exemplary calibration process, a first voltage is sent through the first carbon nanotube layer 302 of the thin film structure 200 of the calibration apparatus 106 to generate a first set of photons of a first blackbody radiation spectrum. The sensor 102 is then calibrated to a first photon flux from the first blackbody radiation spectrum at a selected calibration wavelength, i.e., over a wavelength window corresponding to the selected calibration wavelength. Subsequently, a second voltage is sent through the thin film structure 200 to generate a second set of photons of a second blackbody radiation spectrum. The sensor 102 is then calibrated to the second photon flux from the second blackbody radiation spectrum at the selected calibration wavelength. This process may be repeated any number of times using the same thin film structure 200 to calibrate the sensor 102 at any number of photon fluxes at selected wavelengths before completing the calibration process. In alternate embodiments, a plurality of calibration wavelengths is used, and the plurality of photon fluxes is measured at each of the plurality of calibration wavelengths to calibrate the sensor. At the end of the calibration process, the calibration apparatus 106 is moved or rotated out of the optical path 104 of the sensor 102 so that the sensor 102 can be used for its intended purpose. The ability of the thin film structure 200 to provide multiple calibration wavelengths enables a smaller and lighter calibration apparatus design than known calibration apparatuses that use multiple conventional blackbody radiation sources.

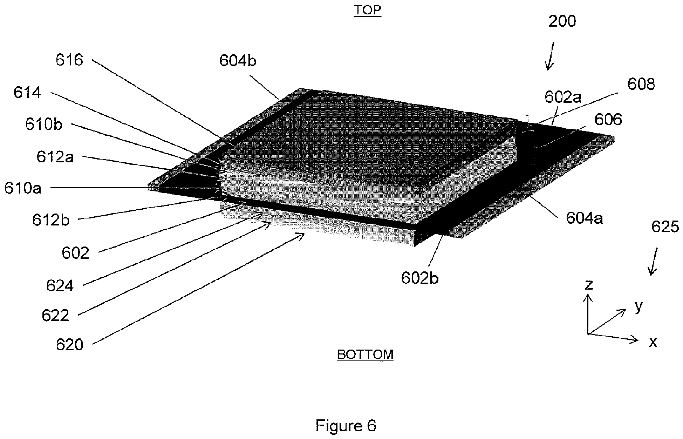

Figure 6 shows a cross-sectional view of the thin film structure 200 of the present disclosure in an alternate embodiment. The thin-film structure 200 includes a first layer (referred to herein as a "first carbon nanotube layer 602") in electrical contact with electrodes 604a and 604b. The electrodes 604a, 604b may be connected to a power supply (not shown) in order to supply a current through the first carbon nanotube layer 602. A top side of the thin-film structure 200 and a bottom side of the thin-film device 200 are labelled in Figure 6 for illustrative and explanatory purposes. The top side is generally in a positive z-direction as indicated by the coordinate system 625. The first carbon nanotube layer 602, as well as the other layers of the thin-film device 200, is considered to lie in the x-y plane of the coordinate system 625. The first carbon nanotube layer 602 includes carbon nanotubes that are oriented in the plane of the first carbon nanotube layer 602. When voltage is applied to the first carbon nanotube layer 602, heat is generated which flows out of either a top face 602a of the first carbon nanotube layer 602 or a bottom face 602b of the first carbon nanotube layer 602. Thermal spreading layer 606 is disposed on the top face 602a of the first carbon nanotube layer 602. A second carbon nanotube layer 608 (referred to herein as a "second carbon nanotube layer 608") is adjoined to the thermal spreading layer 606 so that the thermal spreading layer 606 is sandwiched between the first carbon nanotube layer 602 and the second carbon nanotube layer 608. The second carbon nanotube layer 608 includes a planar surface 614 that are aligned in the x-y plane and a plurality of carbon nanotubes 616 attached to a top of the planar surface 614 and aligned normal to the planar surface (i.e., with longitudinal axes of the plurality of carbon nanotubes 616 aligned in the z-direction). In one embodiment, the planar surface 614 is a layer of alumina substrate (Al₂O₃).

In operating the thin-film structure 200, an applied voltage generates heat at the first carbon nanotube layer 602. The heat is transmitted through the thermal spreading layer 606 to the second carbon nanotube layer 608. At the second carbon nanotube layer 608, the heat excites photons from the plurality of carbon nanotubes 616, which photons are emitted in the positive z-direction. The emitted photons generate a blackbody radiation spectrum.

The spatial distribution of heat generated by the first carbon nanotube 602 tends to vary within the x-y plane. A function of the thermal spreading layer 606 is to reduce this variation of heat within the x-y plane by the time the heat reaches the second carbon nanotube layer 608 so that the temperature and thus the photon emitted flux is even across the surface of the second carbon nanotube layer 608. The structure of the thermal spreading layer 606 is selected so as to achieve this reduction in spatial heat variation.

In particular, the thermal spreading layer 606 includes at least one graphene sheet for distributing heat emanating from the top face 602a of the first carbon nanotube layer 602. The graphene sheet is a compressed layer of graphene platelets. The graphene sheet conducts heat with high efficiency. Thus, the graphene sheet is a highly thermally anisotropic, meaning that heat flows in a plane of the graphene sheet according to a first thermal conductivity and flows normal to the plane of the graphene sheet according to a second thermal conductivity that is much less than the first thermal conductivity. As a result of this thermal anisotropy, graphene is used to reduce any spatial variations in heat density in the plane of the graphene. Since the graphene sheet is aligned in the x-y plane, the variations are smoothed in the x-y plane.

In one embodiment, the thermal spreading layer 606 includes a single graphene sheet between the first carbon nanotube layer 602 and the second carbon nanotube layer 608. In another embodiment, the thermal spreading layer 606 includes a stack of graphene sheets. In the illustrative embodiment of Figure 6, the stack includes at least a first graphene sheet 610a and a second graphene sheet 610b. The first graphene sheet 610a and the second graphene sheet 610b may be joined by an adhesive layer 612a. The adhesive layer 612a is thermally insulating, although not necessarily thermally anisotropic, and allows heat transfer between the first graphene sheet 610a and the second graphene sheet 610b. Additionally, an adhesive layer 612b may be disposed between the first carbon nanotube layer 602 and the first graphene sheet 612a, and an adhesive layer 612c may be disposed between the second carbon nanotube layer 602 and the second graphene sheet 612b. The adhesive layers 612b and 621c may similarly be thermally insulating as, although not necessarily thermally anisotropic. As heat propagates away from the top face 602a of the first carbon nanotube layer 602, the heat is distributed throughout the first graphene sheet 610a in the x-y plane. The heat is then directed from the first graphene sheet 610a to the second graphene sheet 610b. The second graphene sheet 610b further distributes the heat in the x-y plane. Thus both the first graphene sheet 601a and the second graphene sheet 601b are employed in reducing spatial variation of heat in the x-y plane. While two graphene sheets are shown in Figure 6, it is to be understood that any number of graphene sheets may be used in the thermal spreading layer 606 in other embodiments. The use of multiple graphene sheets helps to reduce the non-uniformity in the spatial variation of heat in the x-y plane.

The thin-film structure 200 further includes a reflector 620 disposed on the bottom face 602b of the first carbon nanotube layer 602. The reflector 620 directs heat emanating from the bottom face 602b back in the direction of the first carbon nanotube layer 602. The reflected heat thus passes through the thermal spreading layer 606 and is used to excite photons at the second carbon nanotube layer 608. In one embodiment, a graphene sheet 622 and adhesive layer 624 may be disposed between the first carbon nanotube layer 602 and the reflector 624. Thus, the reflected heat is spatially distributed by the graphene sheet 622.

The thin-film structure 200 of Figure 6 is light weight, typically less than about 40 grams and has a thickness of about 25 mils (0.635 millimeters). Therefore, the thin-film structure may be used in various operations or equipment in which space is restricted and/or in which equipment weight is of concern. The temperature variation of the energy emitted from the top surface of the second carbon nanotube layer 608 is less than about 0.05 K across the surface of the second carbon nanotube layer 608.

The terminology used herein is for the purpose of describing particular embodiments only and is not intended to be limiting of the invention. As used herein, the singular forms "a", "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one more other features, integers, steps, operations, element components, and/or groups thereof.

The description of the present invention has been presented for purposes of illustration and description, but is not intended to be exhaustive or limited to the invention in the form disclosed. Many modifications and variations will be apparent to those of ordinary skill in the art without departing from the scope of the claims. The embodiment was chosen and described in order to best explain the principles of the invention and the practical application, and to enable others of ordinary skill in the art to understand the invention for exemplary embodiments with various modifications as are suited to the particular use contemplated

While the exemplary embodiment to the invention had been described, it will be understood that those skilled in the art, both now and in the future, may make various improvements and enhancements which fall within the scope of the claims which follow.

## Claims

1. An apparatus (200) for producing a blackbody radiation spectrum, for calibration of an optical sensor, comprising:
a first layer (302) configured to generate heat in response to an applied voltage (320);
a second layer (306) configured to emit the blackbody radiation spectrum in response to the heat from the first layer (302); and
a thermal spreading layer (304) between the first layer and the second layer;;
the apparatus being **characterized by**:
the first layer being a first carbon nanotube layer (302);
the second layer being a second carbon nanotube layer (306); and
the thermal spreading layer (304) being a graphene sheet configured to reduce a spatial variation of the heat in a plane of the thermal spreading layer.

2. An apparatus according to claim 1, wherein the apparatus is a film structure.

3. The apparatus of claim 1 or claim 2, wherein the first carbon nanotube layer (302) includes carbon nanotubes aligned in a plane of the first carbon nanotube layer.

4. The apparatus of claim 1, claim 2 or claim 3, wherein the second carbon nanotube layer (306) includes a planar surface and a plurality of carbon nanotubes (312a-312m), wherein a selected carbon nanotube has a longitudinal axis directed substantially normal to the planar surface and emits photons directed along the longitudinal axis in response to the heat from the first carbon nanotube layer (302).

5. The apparatus of any one of claims 1 to 4, wherein the graphene sheet (606) further comprises a graphene stack having at least a first graphene sheet (610a), a second graphene sheet (610b) and a thermally insulating adhesive layer (612a) between the first graphene sheet and the second graphene sheet.

6. The apparatus of claim 2, further comprising a thermally insulating adhesive layer disposed (612c) between the graphene sheet (612b) and the second carbon nanotube layer (608).

7. The apparatus of claim 1, further comprising a reflective layer (620) disposed on a side of the first carbon nanotube layer (602) opposite the thermal spreading layer (606), and a graphene sheet disposed between the first carbon nanotube layer and the reflective layer (620).

8. The apparatus of claim 2, further comprising a reflective layer (620) disposed on a side of the first carbon nanotube (602) layer opposite the thermal spreading layer (606).

9. The apparatus of any preceding claim, further comprising a controllable power supply (320) configured to apply the voltage to the first carbon nanotube layer (302), wherein a characteristic wavelength of the blackbody radiation spectrum is related to a magnitude of the applied voltage at the first carbon nanotube layer (302).

10. A method of producing a blackbody radiation usable for calibration of an optical sensor, comprising:
forming a thin film device including a first carbon nanotube layer (302), a second carbon nanotube layer (306) and at least one graphene sheet disposed between the first carbon nanotube layer (302) and the second carbon nanotube layer (306);
the method being **characterized by**:
applying a voltage to the first carbon nanotube layer (302) of the thin film device in order to generate heat at the first carbon nanotube layer (302);
using the at least one graphene sheet (304) to reduce a spatial variation of the heat in the plane of the thin film device; and
transferring the heat having the reduced spatial variation to the second carbon nanotube layer (306) to excite photons at the second carbon nanotube layer to produce the blackbody radiation spectrum.

11. The method of claim 10, wherein exciting photons at the second carbon nanotube layer (306) further comprises exciting a plurality of carbon nanotubes of the second carbon nanotube layer, wherein a selected carbon nanotube has a longitudinal axis directed substantially normal to a planar surface and emits photons directed along the longitudinal axis in response to the heat.

12. The method of claim 10, wherein the graphene sheet further comprises at least a first graphene sheet (610a), a second graphene sheet (610b) and a thermally insulating adhesive layer (612a) between the first graphene sheet and the second graphene sheet.

13. The method of claim 10, further comprising varying a magnitude of the applied voltage to select a characteristic wavelength of the blackbody radiation spectrum.

14. The method of claim 10, further comprising using a reflective layer (620) of the thin film device to reflect heat from the first layer into the graphene sheet.

## Patentansprüche

1. Vorrichtung (200) zur Herstellung eines Schwarzkörperstrahlungsspektrums zum Kalibrieren eines optischen Sensors,
umfassend:
eine erste Schicht (302), die zum Erzeugen von Wärme als Reaktion auf eine angelegte Spannung (320) ausgelegt ist;
eine zweite Schicht (306), die zum Aussenden des Schwarzkörperstrahlungsspektrums als Reaktion auf die Wärme von der ersten Schicht (302) ausgelegt ist; und
eine thermische Ausbreitungsschicht (304) zwischen der ersten Schicht und der zweiten Schicht; wobei die Vorrichtung **dadurch gekennzeichnet, dass**:
die erste Schicht eine erste Kohlenstoff-Nanoröhrenschicht (302) ist;
die zweite Schicht eine zweite Kohlenstoff-Nanoröhrenschicht (306) ist; und
die thermische Ausbreitungsschicht (304) ein Graphen-Flächenstück ist, das zur Reduzierung einer räumlichen Verteilung der Wärme in einer Ebene der thermischen Ausbreitungsschicht ausgelegt ist.

2. Vorrichtung nach Anspruch 1, wobei die Vorrichtung eine Filmstruktur ist.

3. Vorrichtung nach Anspruch 1 oder Anspruch 2, wobei die erste Kohlenstoff-Nanoröhrenschicht (302) Kohlenstoff-Nanoröhren aufweist, die in einer Ebene der ersten Kohlenstoff-Nanoröhrenschicht ausgerichtet sind.

4. Vorrichtung nach Anspruch 1, Anspruch 2 oder Anspruch 3, wobei die zweite Kohlenstoff-Nanoröhrenschicht (306) eine planare Oberfläche und eine Vielzahl von Kohlenstoff-Nanoröhren (312a-312m) aufweist, wobei eine ausgewählte Kohlenstoff-Nanoröhre eine Längsachse aufweist, die im Wesentlichen normal zur planaren Oberfläche gerichtet ist und als Reaktion auf die Wärme von der ersten Kohlenstoff-Nanoröhrenschicht (302) Photonen aussendet, die entlang der Längsachse gerichtet sind.

5. Vorrichtung nach einem der Ansprüche 1 bis 4, wobei das Graphen-Flächenstück (606) ferner einen Graphenstapel umfasst, der mindestens ein erstes Graphen-Flächenstück (610a), ein zweites Graphen-Flächenstück (610b) und eine wärmeisolierende Klebeschicht (612a) zwischen dem ersten Graphen-Flächenstück und dem zweiten Graphen-Flächenstück aufweist.

6. Vorrichtung nach Anspruch 2, ferner umfassend eine wärmeisolierende Klebeschicht (612c), die zwischen dem Graphen-Flächenstück (612b) und der zweiten Kohlenstoff-Nanoröhrenschicht (608) angeordnet ist.

7. Vorrichtung nach Anspruch 1, ferner umfassend eine reflektierende Schicht (620), die auf einer Seite der ersten Kohlenstoff-Nanoröhrenschicht (602) gegenüber der thermischen Ausbreitungsschicht (606) angeordnet ist, und ein Graphen-Flächenstück, das zwischen der ersten Kohlenstoff-Nanoröhrenschicht und der reflektierenden Schicht (620) angeordnet ist.

8. Vorrichtung nach Anspruch 2, ferner umfassend eine reflektierende Schicht (620), die auf einer Seite der ersten Kohlenstoff-Nanoröhrenschicht (602) gegenüber der thermischen Ausbreitungsschicht (606) angeordnet ist.

9. Vorrichtung nach einem der vorhergehenden Ansprüche, ferner umfassend eine steuerbare Stromversorgung (320), die zum Anlegen einer Spannung an die erste Kohlenstoff-Nanoröhrenschicht (302) ausgelegt ist, wobei eine charakteristische Wellenlänge des Schwarzkörperstrahlungsspektrums zu einer Größe der angelegten Spannung an der ersten Kohlenstoff-Nanoröhrenschicht (302) in Beziehung steht.

10. Verfahren zum Herstellen einer Schwarzkörperstrahlung, die zum Kalibrieren eines optischen Sensors verwendbar ist, umfassend:
Bilden einer Dünnfilmvorrichtung mit einer ersten Kohlenstoff-Nanoröhrenschicht (302), einer zweiten Kohlenstoff-Nanoröhrenschicht (306) und mindestens einem Graphen-Flächenstück, das zwischen der ersten Kohlenstoff-Nanoröhrenschicht (302) und der zweiten Kohlenstoff-Nanoröhrenschicht (306) angeordnet ist;
wobei das Verfahren **gekennzeichnet ist durch**:
Anlegen einer Spannung an die erste Kohlenstoff-Nanoröhrenschicht (302) der Dünnfilmvorrichtung zum Erzeugen von Wärme an der ersten Kohlenstoff-Nanoröhrenschicht (302);
Verwenden des mindestens einen Graphen-Flächenstücks (304) zum Reduzieren einer räumlichen Verteilung der Wärme in der Ebene der Dünnfilmvorrichtung; und
Übertragen der Wärme mit der reduzierten räumlichen Verteilung auf die zweite Kohlenstoff-Nanoröhrenschicht (306) zum Erregen von Photonen an der zweiten Kohlenstoff-Nanoröhrenschicht zur Herstellung des Schwarzkörperstrahlungsspektrums.

11. Verfahren nach Anspruch 10, wobei die Erregung von Photonen an der zweiten Kohlenstoff-Nanoröhrenschicht (306) ferner die Erregung einer Vielzahl von Kohlenstoff-Nanoröhren der zweiten Kohlenstoff-Nanoröhrenschicht umfasst, wobei eine ausgewählte Kohlenstoff-Nanoröhre eine Längsachse aufweist, die im Wesentlichen normal zu einer planaren Oberfläche gerichtet ist und als Reaktion auf die Wärme Photonen aussendet, die entlang der Längsachse gerichtet sind.

12. Verfahren nach Anspruch 10, wobei das Graphen-Flächenstück ferner mindestens ein erstes Graphen-Flächenstück (610a), ein zweites Graphen-Flächenstück (610b) und eine wärmeisolierende Klebeschicht (612a) zwischen dem ersten Graphen-Flächenstück und dem zweiten Graphen-Flächenstück umfasst.

13. Verfahren nach Anspruch 10, ferner umfassend das Variieren einer Größe der angelegten Spannung zum Auswählen einer charakteristischen Wellenlänge des Schwarzkörperstrahlungsspektrums.

14. Verfahren nach Anspruch 10, ferner umfassend das Verwenden einer reflektierenden Schicht (620) der Dünnfilmvorrichtung zum Reflektieren von Wärme von der ersten Schicht in das Graphen-Flächenstück.

## Revendications

1. Appareil (200) pour produire un spectre de rayonnement de corps noir pour calibrer un capteur optique, comprenant:
une première couche (302) configurée de manière à générer de la chaleur en réponse à une tension appliquée (320);
une seconde couche (306) configurée de manière à émettre le spectre de rayonnement de corps noir en réponse à la chaleur émanant de la première couche (302); et
une couche de diffusion thermique (304) entre la première couche et la seconde couche;
l'appareil étant **caractérisé en ce que**:
la première couche est une première couche de nanotubes de carbone (302);
la seconde couche est une seconde couche de nanotubes de carbone (306); et
la couche de diffusion thermique (304) est une feuille de graphène configurée de manière à produire une variation spatiale de la chaleur dans un plan de la couche de diffusion thermique.

2. Appareil selon la revendication 1, dans lequel l'appareil est une structure en film.

3. Appareil selon la revendication 1 ou la revendication 2, dans lequel la première couche de nanotubes de carbone (302) comprend des nanotubes de carbone alignés dans un plan de la première couche de nanotubes de carbone.

4. Appareil selon la revendication 1, la revendication 2 ou la revendication 3, dans lequel la seconde couche de nanotubes de carbone (306) comprend une surface plane et une pluralité de nanotubes de carbone (312a-312m), dans lequel un nanotube de carbone sélectionné présente un axe longitudinal orienté de façon sensiblement normale à la surface plane, et émet des photons dirigés le long de l'axe longitudinal en réponse à la chaleur émanant de la première couche de nanotubes de carbone (302).

5. Appareil selon l'une quelconque des revendications 1 à 4, dans lequel la feuille de graphène (606) comprend en outre une pile de graphène comprenant au moins une première feuille de graphène (610a), une seconde feuille de graphène (610b) et une couche adhésive thermiquement isolante (612a) entre la première feuille de graphène et la seconde feuille de graphène.

6. Appareil selon la revendication 2, comprenant en outre une couche adhésive thermiquement isolante (612c) disposée entre la feuille de graphène (612b) et la seconde couche de nanotubes de carbone (608).

7. Appareil selon la revendication 1, comprenant en outre une couche réfléchissante (620) disposée sur un côté de la première couche de nanotubes de carbone (602) opposé à la couche de diffusion thermique (606), et une feuille de graphène disposée entre la première couche de nanotubes de carbone et la couche réfléchissante.

8. Appareil selon la revendication 2, comprenant en outre une couche réfléchissante (620) disposée sur un côté de la première couche de nanotubes de carbone (602) opposé à la couche de diffusion thermique (606).

9. Appareil selon l'une quelconque des revendications précédentes, comprenant en outre une alimentation électrique commandable (320) configurée de manière à appliquer la tension à la première couche de nanotubes de carbone (302), dans lequel une longueur d'onde caractéristique du spectre de rayonnement de corps noir est liée à une grandeur de la tension appliquée à la première couche de nanotubes de carbone (302).

10. Procédé de production d'un rayonnement de corps noir utilisable pour calibrer un capteur optique, comprenant la formation d'un dispositif en film mince comprenant une première couche de nanotubes de carbone (302), une seconde couche de nanotubes de carbone (306) et au moins une feuille de graphène disposée entre la première couche de nanotubes de carbone (302) et la seconde couche de nanotubes de carbone (306),
le procédé étant en outre **caractérisé par** les étapes suivantes:
appliquer une tension à la première couche de nanotubes de carbone (302) du dispositif en film mince dans le but de générer de la chaleur au niveau de la première couche de nanotubes de carbone (302):
utiliser ladite au moins une feuille de graphène (304) pour réduire une variation spatiale de la chaleur dans le plan du dispositif en film mince; et
transférer la chaleur présentant la variation spatiale réduite à la seconde couche de nanotubes de carbone (306) afin d'exciter des photons au niveau de la seconde couche de nanotubes de carbone dans le but de produire le spectre de rayonnement de corps noir.

11. Procédé selon la revendication 10, dans lequel l'excitation des photons au niveau de la seconde couche de nanotubes de carbone (306) comprend en outre l'excitation d'une pluralité de nanotubes de carbone de la seconde couche de nanotubes de carbone, dans lequel un nanotube de carbone sélectionné présente un axe longitudinal orienté de façon sensiblement normale à une surface plane et émet des photons dirigés le long de l'axe longitudinal en réponse à la chaleur.

12. Procédé selon la revendication 10, dans lequel la feuille de graphène comprend en outre au moins une première feuille de graphène (610a), une seconde feuille de graphène (610b) et une coche adhésive thermiquement isolante (612a) entre la première feuille de graphène et la seconde feuille de graphène.

13. Procédé selon la revendication 10, comprenant en outre la variation d'une grandeur de la tension appliquée pour sélectionner une longueur d'onde caractéristique du spectre de rayonnement de corps noir.

14. Procédé selon la revendication 10, comprenant en outre l'utilisation d'une couche réfléchissante (620) du dispositif en film mince pour réfléchir la chaleur émanant de la première couche dans la feuille de graphène.
